(19)

Europäisches Patentamt

European Patent Office

Office européen des brevets

(11) **EP 4 019 919 A1**

(12) **EUROPEAN PATENT APPLICATION**
published in accordance with Art. 153(4) EPC

(43) Date of publication:
**29.06.2022   Bulletin 2022/26**

(21) Application number: **20867728.6**

(22) Date of filing: **16.06.2020**

(51) International Patent Classification (IPC):
***G01K 11/00*** *(2006.01)*

(86) International application number:
**PCT/CN2020/096329**

(87) International publication number:
**WO 2021/057110 (01.04.2021 Gazette 2021/13)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority:  **29.09.2019   CN 201910933302**

(71) Applicant: **Zhuzhou National Innovation Railway Technology**
**Co., Ltd.**
**Zhuzhou, Hunan 412000 (CN)**

(72) Inventors:
  • **LI, Lin**
    **Zhuzhou, Hunan412000 (CN)**
  • **Yang, Ying**
    **Zhuzhou, Hunan412000 (CN)**
  • **MO, Hongbo**
    **Zhuzhou, Hunan412000 (CN)**
  • **XIAO, Liya**
    **Zhuzhou, Hunan412000 (CN)**
  • **LIU, Yi**
    **Zhuzhou, Hunan412000 (CN)**
  • **JIANG, Xiaolin**
    **Zhuzhou, Hunan412000 (CN)**
  • **XIE, Jin**
    **Zhuzhou, Hunan412000 (CN)**
  • **LIU, Hailong**
    **Zhuzhou, Hunan412000 (CN)**
  • **Shen, Yiping**
    **Zhuzhou, Hunan412000 (CN)**
  • **Zhang, Jingfu**
    **Zhuzhou, Hunan412000 (CN)**
  • **TAN, Yu**
    **Zhuzhou, Hunan412000 (CN)**

(74) Representative: **Behr, Wolfgang**
    **Lorenz Seidler Gossel**
    **Rechtsanwälte Patentanwälte**
    **Partnerschaft mbB**
    **Widenmayerstraße 23**
    **80538 München (DE)**

(54) **METAMATERIAL TEMPERATURE-SENSING SENSOR, PREPARATION METHOD, AND APPLICATION THEREOF**

(57)    Provided is a metamaterial temperature-sensing sensor, comprising a base (3) and a metamaterial structure attached to the base (3); the metamaterial structure comprises a nano-porous frame layer (1) and a nano-sensing material (2) embedded in the nanopores, the reflection characteristic peak of the nano-sensing material (2) having a correlation with the temperature. The corresponding preparation method comprises: S01. preparing a nano-porous frame layer (1): sputtering a layer of metallic aluminum or metallic titanium onto a base (3), carrying out an electrochemical anodic redox reaction in a reaction solution, and generating a nano-porous frame layer (1) having a regularly arranged structure; S02. depositing in the nanopores to form a nano-sensing material (2). Provided is a pantograph temperature measurement apparatus, comprising a signal emitter (4), a signal receiver (5), and a metamaterial temperature -sensing sensor; the metamaterial temperature-sensing sensor is mounted on the pantograph. The sensor and the apparatus have advantages such as a simple structure, high responsiveness, high reliability, and low cost.

FIG. 1

EP 4 019 919 A1

**Description**

TECHNICAL FIELD

The invention mainly relates to the technical field of temperature measurement, in particular to a metamaterial temperature-sensing sensor, and a preparation method and application thereof.

DESCRIPTION OF RELATED ART

The fire safety and reliable operation of railway vehicles are of important practical significance. However, there are many underlying factors that may affect the safety of the railway vehicles due to excessive temperature during operation of the vehicles. For example, the pantograph, as a common current-receiving device adopted by railway vehicles (high-speed trains, locomotives and subway vehicles) in China at present, generally has the problems of eccentric abrasion of a pantograph slider, looseness of screws and arcing faults of a pantograph-OCS system. Due to the supply of large-current power, a fault of the pantograph-OCS system may result in burnout of a contact wire and breakage of the pantograph; moreover, an operating temperature of over 100°C may lead to trip-out of a power supply system of vehicles and damage to the vehicles and may directly cause an operation stop of the vehicles, which will in turn lead to a serious consequence. All these pantograph faults are reflected by overheat. So, real-time online detection of the temperature of the pantograph-OCS system during operation of vehicles is of great significance for guaranteeing safety and stable operation of vehicles.

At present, the temperature of the pantograph-OCS system is monitored through the following methods: manual detection and infrared thermal imaging detection, wherein the manual detection method depends on detection of the power supply network in factory and during installation and manual detection of the abrasion and exceptions of the pantograph and the OCS system at the top, so this detection method is low in working efficiency, poor in safety and high in intensity, may disturb vehicle operation during work, and cannot realize real-time detection; the infrared thermal imaging method relies on detection of the temperature of cable cleats of the pantograph-OCS system by means of a high-speed infrared camera, but this detection method may be affected by the environment of the detection position, for example, when strong sunlight enters the site during the detection process, a light spot at a high temperature will be formed on an image, which will in turn cause system misjudgments; and the temperature detection will be seriously affected in severe environments such as in hail, rain and snow environments. Video surveillance has also been applied to an online monitoring system to acquire the contact condition of the pantograph-OCS system through a high-speed camera and then carry out fault recognition and state analysis through image processing, but this method may also be affected by the weather and environment and is high in cost.

BRIEF SUMMARY OF THE INVENTION

The technical issue to be settled by the invention is to solve the technical problems of the prior art by providing a metamaterial temperature-sensing sensor which is simple in structure and good in temperature detection timeliness, and also providing a preparation method easy to operate, as well as a pantograph temperature detection device which is simple in structure, high in responsivity and reliability, and low in cost.

In order to solve the above problems, the present invention adopts the following technical solutions:

A metamaterial temperature-sensing sensor, comprising a base and a metamaterial structure attached to the base , wherein the metamaterial structure comprises a nano-porous frame layer and nano-sensing materials inlaid in nano-pores, and a corresponding relationship exists between a reflection characteristic peak of the nano-sensing materials and temperature.

As further improvement of the above technical solution:

The base is prepared from alumina ceramic, sapphire, quartz or magnesium-aluminum spinel.

A diameter of the nano-pores of the nano-porous frame layer is within a preset range to guarantee that a size of the nano-sensing materials inlaid in the nano-pores allows the nano-sensing materials to have an absorption and reflection effect on visible light with different wavelengths,.

In addition, the present invention also provides a preparation method of the metamaterial temperature-sensing sensor comprising the following steps:

S01: preparing a nano-porous frame layer : sputtering a layer of metallic aluminum or metallic titanium on a base , carrying out an electrochemical anodic oxidation reduction reaction in a reaction solution by using the base sputtered with the metallic aluminum or the metallic titanium as an anode for the reaction and using a metallic aluminum sheet as a cathode for the reaction, and forming a nano-porous aluminum oxide or a titanium oxide of a regular arrangement structure through the reaction of the metallic aluminum or the metallic titanium to serve as the nano-porous frame layer;
S02: depositing a nano-metal in nano-pores of the nano-porous frame layer to form nano-sensing materials .

As further improvement of the above technical solution:

A specific process of S02 is as follows: a screen printing plate is disposed on the nano-porous frame layer ; then, nano-metal slurry is screen-printed to flow into the nano-pores and is then dried in shade and subjected to gradient sintering, so that the nano-metal is deposited in the nano-pores to form the nano-sensing materials .

A specific process of S02 is as follows: metal particles are deposited in the nano-pores through in-situ growth of the nano-metal to be used as in-site growth points, the nano-porous frame layer is placed in a reaction solution containing to-be-deposited nano-metal ions, and the nano-metal are deposited in the nano-pores to form the nano-sensing materials .

The nano-metal is one of gold, silver, platinum and palladium, or is an alloy formed by multiple nano-metals.

In addition, the present invention also provides a pantograph temperature detection device, comprising a signal emitter , a signal receiver , and the metamaterial temperature-sensing sensor; wherein the metamaterial temperature-sensing sensor is installed on a pantograph, the signal emitter is used for emitting visible light to the metamaterial temperature-sensing sensor, the signal receiver is used for receiving light reflected by the metamaterial temperature-sensing sensor, and a wavelength or reflection intensity of a reflection characteristic peak is obtained by analysis, so that a corresponding temperature of the pantograph is obtained.

As further improvement of the above technical solution:

The signal emitter and the signal receiver are symmetrically distributed on two sides of the metamaterial temperature-sensing sensor at a same angle to guarantee coupling of light paths
The signal emitter is a visible light source, and the signal receiver is a spectrum analyzer.

Compared with the prior art, the invention has the following advantages:
According to the metamaterial temperature-sensing sensor and the preparation method thereof, because of the corresponding relationship between the reflection characteristic peak of nano-sensing materials and the temperature, when the temperature changes, corresponding temperature information can be obtained by sensing a change of the reflection characteristic peak; the reflection characteristic peak of the nano-sensing materials is sensitive to the temperature, so that a temperature value can be obtained in time; in addition, the nano-sensing materials are inlaid in nano-pores of a nano-porous frame layer, thus being highly tolerant to the temperature; and the overall structure is simple, and the preparation process is easy to implement.

The pantograph temperature detection device of the invention uses the metamaterial temperature-sensing sensor mentioned above, and measures the temperature of a pantograph by emitting visible light and receiving reflected light for analysis; because of the high light transmission speed and the sensitivity of the optical property, such as the dielectric constant, of the nano-sensing materials to environmental temperature changes, the timeliness of temperature measurement is guaranteed; in addition, the influence of electromagnetism in the pantograph is avoided, system misjudgments caused by weather and environment changes are also avoided, and the reliability is high; and the pantograph temperature detection device is simple in overall structure and low in cost.

BRIEF DESCRIPTION OF THE SEVERAL VIEWS OF THE DRAWINGS

FIG. 1 is a front view of a sensor in an embodiment of the invention.
FIG. 2 is a view along A-A in FIG. 1.
FIG. 3 is a structural view of a specific application embodiment of the sensor of the invention.
FIG. 4 is a curved chart of characteristic peaks at different temperatures of the invention.

Reference signs in the figures: 1, nano-porous frame layer; 2, nano-sensing material; 3, base; 4, signal emitter; 5, signal receiver.

DETAILED DESCRIPTION OF THE INVENTION

The invention will be further described below in conjunction with the accompanying drawings and specific embodiments of the invention.

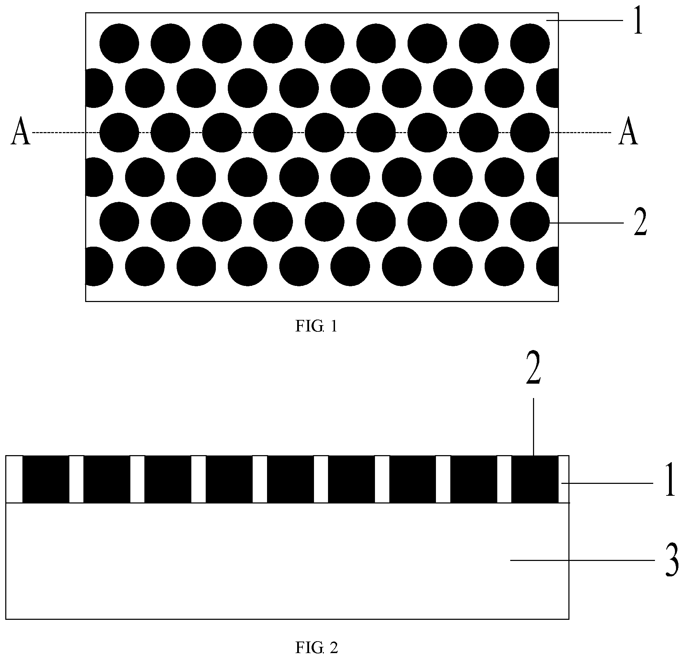

As shown in FIG. 1 and FIG. 2, this embodiment provides a metamaterial temperature-sensing sensor, comprising a base 3 and a metamaterial structure attached to the base 3, wherein the metamaterial structure comprises a nano-porous frame layer 1 and nano-sensing materials 2 inlaid in nano-pores, and a corresponding relationship exists between the reflection characteristic peak of the nano-sensing materials 2 and temperature.

In this embodiment, the base 3 is used to support the metamaterial structure and is prepared from one of alumina ceramic, sapphire, quartz and magnesium-aluminum spinel. For different nano-sensing materials 2, planar base 3 materials with a coefficient of thermal expansion being similar to that of the nano-sensing materials 2 should be selected.

In this embodiment, the nano-pores's diameter of the nano-porous frame layer 1 should guarantee that the size of the nano-sensing material 2 embedded in the nano-pores, which makes the nano-sensing material 2 have absorption and reflection effects on visible light with different wavelengths. The diameter of the nano-pores of the nano-porous frame layer 1 is optimized to be 10-500nm. In other embodiments, the diameter of the nano-pores is selected according to actual conditions. In addition, the nano-pores are arranged regularly. As shown in FIG. 1, the nano-pores are parallelly arranged in multiple rows, and the nano-pores in every two adjacent rows are staggered. The nano-porous frame layer 1 of this structure improves the tolerance to environment of the nano-sensing materials 2.

In this embodiment, the nano-sensing materials 2 have an absorption effect on visible light with some wavelengths and will not absorb visual light with other wavelengths, which is reflected by an obvious reflection characteristic peak on a reflection spectrum. The reflection characteristic peak is obtained according to the following formula:

$$\sigma_{abs}\left(\omega\right) = \frac{V}{3c}\varepsilon_m^{3/2}\sum_{i=1}^{3}\left(Y_i+1\right)^2\frac{\omega\varepsilon_2}{\left(\varepsilon_1+Y_i\varepsilon_m\right)^2+\varepsilon_2^2}$$

Wherein, $\varepsilon_1$ and $\varepsilon_2$ are a real part and an imaginary part of a dielectric constant of the nano-sensing materials 2 respectively, $\varepsilon_m$ is a dielectric constant of a nano-porous frame material, and $Y_i$ is a shape factor of the nano-sensing materials 2 (a ratio of a long-axis size to a short-axis size of the nano-sensing materials 2). In terms of the this formula, the characteristic peak occurs under the condition of $\varepsilon_1 = -Y_i\varepsilon_m$;

Wherein, the optical property of the nano-sensing materials 2, such as the influence of temperature on a relative dielectric constant related to visible light absorption and reflection, is obtained according to the following formula:

$$\varepsilon_r\left(T\right) = \varepsilon_\infty - \frac{\omega_p^2\left(T\right)}{\omega\left(\omega+i\omega_c\left(T\right)\right)}$$

Wherein, $\omega$ is an angular frequency of visible light waves, $\varepsilon\infty$ is a high-frequency dielectric constant related to the nano-sensing materials 2, $\omega_p(T)$ is a plasma frequency of the nano-sensing materials 2 at a temperature T, and $\omega_c(T)$ is an electron scattering frequency of the nano-sensing materials 2 at the temperature T; a temperature change of a pantograph will affect the dielectric constant of the nano-sensing materials 2, thus affecting the absorption and reflection to visible light of the nano-sensing materials 2.

If the influence of only one variable is considered, the dielectric constant of the nano-sensing materials 2 changes when the temperature changes, which leads to a change to the wavelength or reflection intensity of the reflection characteristic peak, so corresponding temperature information can be obtained by accurately sensing the change of the reflection characteristic peak in real time; and a linear relationship between the temperature and the reflection characteristic peak can be realized through a reasonable design to fulfill real-time monitoring of temperature changes.

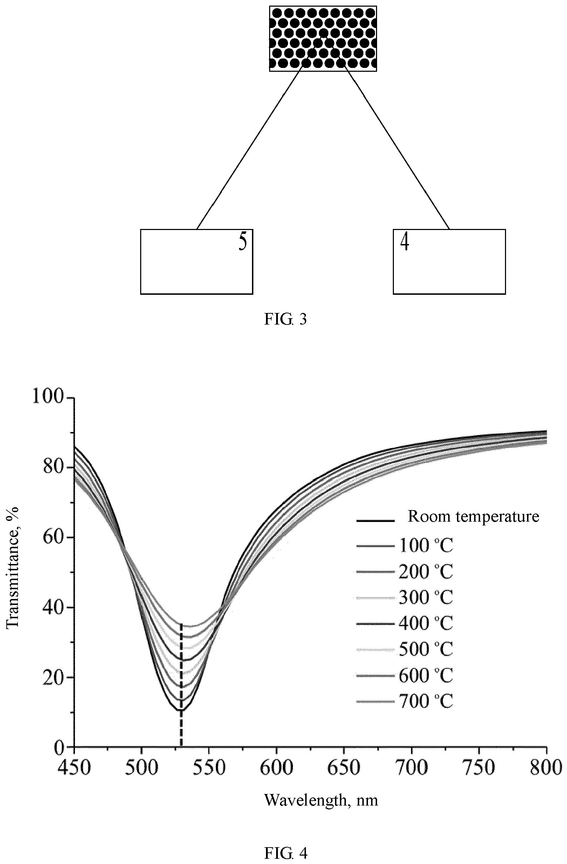

Specifically, in terms of the above two formulas, a transmittance spectrum of the metamaterial temperature-sensing sensor within a visual light range (450-800nm) at different temperatures can be obtained through time-domain finite-difference numerical simulation by means of software Lumerical FDTD. As shown below, when the temperature rises from indoor temperature to 700°C, the characteristic peak in the transmittance spectrum increases from 529nm to 539nm. Wherein, the temperatures, corresponding to the dotted line, in the curves in FIG. 4 are the indoor temperature (25°C), 100°C, 200°C, 300°C, 400°C, 500°C, 600°C and 700°C sequentially from bottom to top.

According to the metamaterial temperature-sensing sensor, because of the corresponding relationship between the reflection characteristic peak of the nano-sensing materials 2 and the temperature, when the temperature changes, corresponding temperature information can be obtained by sensing a change of the reflection characteristic peak; the nano-sensing materials 2 are inlaid in the nano-pores of the nano-porous frame layer 1, thus being highly tolerant to the temperature; and the overall structure of the metamaterial temperature-sensing sensor is simple.

Correspondingly, the invention further discloses a preparation method of the metamaterial temperature-sensing sensor, comprising the following steps:

S01: preparing a nano-porous frame layer 1: sputtering a layer of metallic aluminum or metallic titanium on a base 3, carrying out an electrochemical anodic oxidation reduction reaction in a reaction solution (such as dilute sulfuric acid, dilute phosphoric acid or sodium hydroxide) by using the base 3 sputtered with the metallic aluminum or the metallic titanium as an anode for the reaction and using a metallic aluminum sheet as a cathode for the reaction, and forming a nano-porous aluminum oxide or a titanium oxide of a regular arrangement structure through the reaction of the metallic aluminum or the metallic titanium to serve as the nano-porous frame layer 1; and

S02: depositing a nano-metal in nano-pores of the nano-porous frame layer 1 to form nano-sensing materials 2.

In this embodiment, the specific process of S02 is as follows: a screen printing plate is disposed on the nano-porous frame layer 1; then, nano-metal slurry is screen-printed to flow into the nano-pores, is dried in shade, and is then placed in a high-temperature sintering furnace to be subjected to gradient sintering, so that the nano-metal is deposited in the nano-pores to form the nano-sensing materials 2. In other embodiments, metal particles are deposited in the nano-pores through in-situ growth of the nano-metal to be used as in-site growth points, the nano-porous frame layer 1 is placed in a reaction solution containing to-be-deposited nano-metal ions, and the nano-metal ions are deposited in the nano-pores to form the nano-sensing materials 2. The nano-sensing materials 2 have an absorption effect on visible light with some wavelengths and will not absorb visible light with other wavelengths, which is reflected by an obvious reflection characteristic peak on a reflection spectrum. In addition, the nano-metal is one of gold, silver, platinum and palladium, or is an alloy formed by multiple nano-metals (such as a silver-platinum alloy).

The preparation method of the metamaterial temperature-sensing sensor has a simple preparation process.

Based on the properties of the nano-sensing materials 2 in the metamaterial temperature-sensing sensor, the metamaterial temperature-sensing sensor is used for temperature measurement of a pantograph to form a pantograph temperature detection device, which specifically comprises a signal emitter 4, a signal receiver 5 and the metamaterial temperature-sensing sensor, wherein the metamaterial temperature-sensing sensor is installed on the surface of the pantograph (firmly attached to the surface of the pantograph through the base 3), the signal emitter 4 and the signal receiver 5 are installed at the top of a train, the signal emitter 4 is used for emitting visible light to the metamaterial temperature-sensing sensor, the signal receiver 5 is used for receiving light reflected by the metamaterial temperature-sensing sensor, and the wavelength or reflection intensity of a reflection characteristic peak is obtained by analysis, so that the corresponding temperature of the pantograph is obtained. Because the optical property (such as the dielectric constant) of the nano-sensing materials 2 is sensitive to changes of the environmental temperature, when the temperature of the pantograph changes, the dielectric constant of the nano-sensing materials 2 will change accordingly, which in turn leads to a change to the wavelength or reflection intensity of the reflection characteristic peak, so the temperature change of the pantograph can be monitored in real time according to the corresponding relationship between the temperature and the reflection characteristic peak.

The pantograph temperature detection device of the invention uses the metamaterial temperature-sensing sensor mentioned above, and measures the temperature of a pantograph by emitting visible light and receiving reflected light for analysis; because of the high light transmission speed and the sensitivity of the optical property, such as the dielectric constant, of the nano-sensing materials to environmental temperature changes, the timeliness of temperature measurement is guaranteed; in addition, the influence of electromagnetism in the pantograph is avoided, and system misjudgments caused by weather and environment changes are also avoided; and the pantograph temperature detection device is simple in overall structure and low in cost.

As shown in FIG. 3, in this embodiment, the installation site of the metamaterial temperature-sensing sensor on the pantograph should be located on a propagation path of visible light; meanwhile, it should be ensured that the visible light enters the metamaterial temperature-sensing sensor at a certain angle with respect to the planar normal direction of the metamaterial temperature-sensing sensor and a reflected signal returns to the signal receiver 5 at the same angle, so the signal emitter 4 and the signal receiver 5 should be symmetrically distributed on two sides of the metamaterial temperature-sensing sensor at the same angle to guarantee coupling of light paths. Wherein, the signal emitter 4 is a visible light source for emitting visible light, and the signal receiver 5 is a spectrum analyzer. The pantograph temperature detection device is simple in structure and easy to implement.

The above is merely preferred implementation modes of the present invention. The scope of protection of the present invention is not limited to the above embodiment. Technical schemes under the concept of the present invention shall fall into the scope of protection of the present invention. It is to be noted that improvements and embellishments shall be made within the protection range of the disclosure to those skilled in the technical field without departing the principle of the present invention.

**Claims**

1. A metamaterial temperature-sensing sensor, comprising a base (3) and a metamaterial structure attached to the base (3), **characterized in that** the metamaterial structure comprises a nano-porous frame layer (1) and nano-sensing materials (2) inlaid in nano-pores, and a corresponding relationship exists between a reflection characteristic peak of the nano-sensing materials (2) and temperature.

2. The metamaterial temperature-sensing sensor according to claim 1, **characterized in that** the base (3) is prepared from alumina ceramic, sapphire, quartz or magnesium-aluminum spinel.

3. The metamaterial temperature-sensing sensor according to claim 1, **characterized in that** a diameter of the nano-pores of the nano-porous frame layer (1) is within a preset range to guarantee that a size of the nano-sensing materials (2) inlaid in the nano-pores allows the nano-sensing materials (2) to have an absorption and reflection effect on visible light with different wavelengths,.

4. A preparation method of the metamaterial temperature-sensing sensor according to any one of claims 1 to 3, **characterized by** comprising the following steps:

   S01: preparing a nano-porous frame layer (1): sputtering a layer of metallic aluminum or metallic titanium on a base (3), carrying out an electrochemical anodic oxidation reduction reaction in a reaction solution by using the base (3) sputtered with the metallic aluminum or the metallic titanium as an anode for the reaction and using a metallic aluminum sheet as a cathode for the reaction, and forming a nano-porous aluminum oxide or a titanium oxide of a regular arrangement structure through the reaction of the metallic aluminum or the metallic titanium to serve as the nano-porous frame layer (1);
   S02: depositing a nano-metal in nano-pores of the nano-porous frame layer (1) to form nano-sensing materials (2).

5. The preparation method according to claim 4, **characterized in that** a specific process of S02 is as follows: a screen printing plate is disposed on the nano-porous frame layer (1); then, nano-metal slurry is screen-printed to flow into the nano-pores and is then dried in shade and subjected to gradient sintering, so that the nano-metal is deposited in the nano-pores to form the nano-sensing materials (2).

6. The preparation method according to claim 4, **characterized in that** a specific process of S02 is as follows: metal particles are deposited in the nano-pores through in-situ growth of the nano-metal to be used as in-site growth points, the nano-porous frame layer (1) is placed in a reaction solution containing to-be-deposited nano-metal ions, and the nano-metal are deposited in the nano-pores to form the nano-sensing materials (2).

7. The preparation method according to any one of claims 4 to 6, **characterized in that** the nano-metal is one of gold, silver, platinum and palladium, or is an alloy formed by multiple nano-metals.

8. A pantograph temperature detection device, **characterized in that** comprising a signal emitter (4), a signal receiver (5), and the metamaterial temperature-sensing sensor according to any one of claims 1 to 3, wherein the metamaterial temperature-sensing sensor is installed on a pantograph, the signal emitter (4) is used for emitting visible light to the metamaterial temperature-sensing sensor, the signal receiver (5) is used for receiving light reflected by the metamaterial temperature-sensing sensor, and a wavelength or reflection intensity of a reflection characteristic peak is obtained by analysis, so that a corresponding temperature of the pantograph is obtained.

9. The pantograph temperature detection device according to claim 8, **characterized in that** the signal emitter (4) and the signal receiver (5) are symmetrically distributed on two sides of the metamaterial temperature-sensing sensor at a same angle to guarantee coupling of light paths

10. The pantograph temperature detection device according to claim 8 or 9, **characterized in that** the signal emitter (4) is a visible light source, and the signal receiver (5) is a spectrum analyzer.

1

2

A - - - - - - - - - - - A

FIG. 1

2

1

3

FIG. 2

FIG. 3

FIG. 4

## INTERNATIONAL SEARCH REPORT

| | International application No. |
|---|---|
| | **PCT/CN2020/096329** |

### A. CLASSIFICATION OF SUBJECT MATTER

G01K 11/00(2006.01)i

According to International Patent Classification (IPC) or to both national classification and IPC

### B. FIELDS SEARCHED

Minimum documentation searched (classification system followed by classification symbols)

G01K

Documentation searched other than minimum documentation to the extent that such documents are included in the fields searched

Electronic data base consulted during the international search (name of data base and, where practicable, search terms used)

CNPAT, CNKI, EPODOC, WPI: 反射特征峰, 阳极, 峰, 阴极, 波长, 反射, 吸收, 光谱, 株洲国创轨道, 超材料, 孔, 介电常数, 温度, 纳米, 强度, metamaterial, sensor , temperature , nano, pore, layer , metal , characteristic peak, wavelengh, reflect+, absorb+, spectrum, intensity

### C. DOCUMENTS CONSIDERED TO BE RELEVANT

| Category* | Citation of document, with indication, where appropriate, of the relevant passages | Relevant to claim No. |
|---|---|---|
| PX | CN 111024257 A (ZHUZHOU GUOCHUANG TRACK TECHNOLOGY CO., LTD.) 17 April 2020 (2020-04-17)<br>description, paragraphs [0030]-[0049], and figures 1-4 | 1-10 |
| Y | CN 107907237 A (JIANGXI NORMAL UNIVERSITY) 13 April 2018 (2018-04-13)<br>description, paragraphs [0032]-[0057], and figures 1-5 | 1-10 |
| Y | CN 107002273 A (CONSEJO SUPERIOR INVESTIGACION) 01 August 2017 (2017-08-01)<br>description, paragraphs [0014], [0066]-[0073] and [0082]-[0084], and figures 1 and 10 | 1-10 |
| Y | CN 202307819 U (BRILLIANT LIGHT TECHNOLOGIES) 04 July 2012 (2012-07-04)<br>description, paragraphs [0117]-[0146], and figures 4-5 | 8-10, |
| A | CN 205862521 U (ZIBO WENGUANG ELECTRIC CO., LTD.) 04 January 2017 (2017-01-04)<br>entire document | 1-10 |
| A | US 2018329115 A1 (PURDUE RESEARCH FOUNDATION) 15 November 2018 (2018-11-15)<br>entire document | 1-10 |

☐ Further documents are listed in the continuation of Box C.  ☑ See patent family annex.

\* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **18 August 2020** | **27 August 2020** |

| Name and mailing address of the ISA/CN | Authorized officer |
|---|---|
| **China National Intellectual Property Administration (ISA/ CN)**<br>**No. 6, Xitucheng Road, Jimenqiao Haidian District, Beijing 100088**<br>**China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2020/096329**

| Patent document cited in search report | | | Publication date (day/month/year) | Patent family member(s) | | | Publication date (day/month/year) |
|---|---|---|---|---|---|---|---|
| CN | 111024257 | A | 17 April 2020 | None | | | |
| CN | 107907237 | A | 13 April 2018 | CN | 107907237 | B | 19 November 2019 |
| CN | 107002273 | A | 01 August 2017 | EP | 3168331 | A1 | 17 May 2017 |
| | | | | US | 2017221597 | A1 | 03 August 2017 |
| | | | | WO | 2016005636 | A1 | 14 January 2016 |
| | | | | ES | 2559275 | B1 | 22 November 2016 |
| | | | | ES | 2559275 | A1 | 11 February 2016 |
| CN | 202307819 | U | 04 July 2012 | None | | | |
| CN | 205862521 | U | 04 January 2017 | None | | | |
| US | 2018329115 | A1 | 15 November 2018 | US | 10670772 | B2 | 02 June 2020 |

Form PCT/ISA/210 (patent family annex) (January 2015)